(19) Europäisches Patentamt
European Patent Office
Office européen des brevets

(11) **EP 4 644 990 A1**

(12) **EUROPEAN PATENT APPLICATION**
published in accordance with Art. 153(4) EPC

(43) Date of publication:
**05.11.2025 Bulletin 2025/45**

(21) Application number: **24749902.3**

(22) Date of filing: **12.01.2024**

(51) International Patent Classification (IPC):
***G03F 1/62*** (2012.01)     ***C01B 32/168*** (2017.01)

(52) Cooperative Patent Classification (CPC):
**C01B 32/168; G03F 1/62**

(86) International application number:
**PCT/JP2024/000599**

(87) International publication number:
**WO 2024/161947 (08.08.2024 Gazette 2024/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **03.02.2023  JP 2023015650**

(71) Applicant: **Mitsui Chemicals, Inc.
Tokyo 104-0028 (JP)**

(72) Inventors:
• **FUJIMURA, Masashi
Sodegaura-shi, Chiba 299-0265 (JP)**

• **ISHIKAWA, Hisako
Sodegaura-shi, Chiba 299-0265 (JP)**
• **ONO, Yosuke
Sodegaura-shi, Chiba 299-0265 (JP)**
• **OKUBO, Atsushi
Sodegaura-shi, Chiba 299-0265 (JP)**
• **MOMOSE, Haruka
Sodegaura-shi, Chiba 299-0265 (JP)**

(74) Representative: **Hoffmann Eitle
Patent- und Rechtsanwälte PartmbB
Arabellastraße 30
81925 München (DE)**

(54) **NANOTUBE PELLICLE FILM, PELLICLE, EXPOSURE PRECURSOR, AND EXPOSURE DEVICE**

(57)     A nanotube pellicle film of the disclosure has a ratio of ventilation resistance to a film thickness of 0.015 Pa·cm$^2$/(sccm·nm) or more.

EP 4 644 990 A1

**Description**

Technical Field

The present disclosure relates to a nanotube pellicle film, a pellicle, an exposure original plate, and an exposure device.

Background Art

The miniaturization of semiconductor integrated circuits has been promoted by photolithography. In the photolithography, a transparent substrate (hereinafter, referred to as "photomask") having a pattern formed on one surface is used. A pellicle is attached to the photomask in order to prevent foreign matter, such as dust, from adhering to the surface of the photomask. The pellicle includes a pellicle film through which exposure light is transmitted, and a pellicle frame supporting the pellicle film.

Patent Literature 1 discloses a pellicle film used for extreme ultraviolet lithography using extreme ultraviolet (hereinafter, also referred to as "EUV"). The pellicle film disclosed in Patent Literature 1 includes a plurality of carbon nanotubes (hereinafter, also referred to as "CNT") forming a network structure. The thickness of the network structure is from 3 nm to 100 nm. The transmittance of EUV of the network structure is 92% or more. The plurality of CNTs include at least 50% or more of double-walled carbon nanotubes.

Patent Literature 1: WO 2022/060877 A1

SUMMARY OF INVENTION

Technical Problem

In the extreme ultraviolet lithography, EUV exposure is performed by moving a pellicle-attached photomask having a pellicle attached to the photomask at a high speed. In a case in which the film thickness of the pellicle film is relatively thick, the transmittance of EUV decreases, and there is a possibility that it takes time for EUV exposure. In a case in which the film thickness of the pellicle film is thin, the pellicle film may be easily broken. Therefore, a pellicle film that is difficult to break even in the case of having a thin film thickness is required.

The disclosure has been made in view of the above circumstances.

A problem to be solved by an embodiment of the disclosure is to provide a nanotube pellicle film, which is difficult to break even in the case of having a thin film thickness, a pellicle, an exposure original plate, and an exposure device.

Solution to Problem

Means for solving the above problems include the following embodiments.

<1> A nanotube pellicle film having a ratio of ventilation resistance to a film thickness of 0.015 Pa·cm$^2$/(sccm·nm) or more.

<2> The nanotube pellicle film described in <1>, including a plurality of nanotubes having a tube diameter of from 0.8 nm to 6.0 nm,
in which a content ratio of the plurality of nanotubes is 80 mass% or more with respect to a total amount of the nanotube pellicle film.

<3> The nanotube pellicle film described in <1> or <2>, including a plurality of single-walled nanotubes,
in which a content ratio of the plurality of single-walled nanotubes is 80 mass% or more with respect to a total amount of the nanotube pellicle film.

<4> The nanotube pellicle film described in any one of <1> to <3>, in which the ratio is from 0.015 Pa·cm$^2$/(sccm·nm) to 0.130 Pa·cm$^2$/(sccm·nm).

<5> The nanotube pellicle film described in any one of <1> to <4>, including a plurality of carbon nanotubes,
in which a ratio of a G-band intensity measured by resonance Raman scattering measurement method to a D-band intensity measured by resonance Raman scattering measurement method is 5 or more.

<6> The nanotube pellicle film described in any one of <1> to <5>, including a plurality of nanotubes,

in which the nanotubes are one selected from the group consisting of carbon nanotubes, boron nitride nanotubes, and transition metal disulfide nanotubes,
the transition metal disulfide nanotubes include a transition metal disulfide,
the transition metal disulfide is represented by MX$_2$,

M is at least one selected from the group consisting of Mo, W, Pd, Pt, and Hf, and
X is at least one selected from the group consisting of S, Se, and Te.

<7> The nanotube pellicle film described in <6>, in which the nanotubes are carbon nanotubes.

<8> The nanotube pellicle film described in any one of <1> to <7>, in which a transmittance of extreme ultraviolet rays is 88% or more.

<9> The nanotube pellicle film described in any one of <1> to <8>, in which a maximum stress is 120 MPa or more.

<10> The nanotube pellicle film described in any one of <1> to <9>, in which a deflection amount in a case in which the nanotube pellicle film is formed into a 1 cm square is 200 $\mu$m or less.

<11> A pellicle, including:

a pellicle frame; and
the pellicle film described in any one of <1> to <10>, supported by the pellicle frame.

<12> An exposure original plate, including:

a photomask; and
the pellicle described in <11>, attached to the photomask.

<13> An exposure device, including:

an extreme ultraviolet light source emitting extreme ultraviolet rays as exposure light;
the exposure original plate described in <12>; and
an optical system guiding the exposure light emitted from the extreme ultraviolet light source to the exposure original plate,
in which the exposure original plate is disposed such that the extreme ultraviolet rays emitted from the extreme ultraviolet light source pass through the nanotube pellicle film to be irradiated on the photomask.

Advantageous Effects of Invention

According to an embodiment of the disclosure, there are provided a nanotube pellicle film, which is difficult to break even in the case of having a thin film thickness, a pellicle, and an exposure original plate.

BRIEF DESCRIPTION OF DRAWINGS

Fig. 1 is a schematic view illustrating a measurement device in a bulge test.
Fig. 2 is a graph showing a pressure difference between the inside and the outside of a pellicle with respect to elapsed time in a bulge test.

DESCRIPTION OF EMBODIMENTS

In the disclosure, a numerical range that has been indicated by use of "to" indicates the range that includes the numerical values which are described before and after "to", as a minimum value and a maximum value, respectively.

In a numerical range described in a stepwise manner in the disclosure, an upper limit value or a lower limit value described in one numerical range may be replaced with an upper limit value or a lower limit value described in another numerical range described in a stepwise manner. In a numerical range described in the disclosure, an upper limit value or a lower limit value described in a certain numerical range may be replaced with a value shown in Examples.

In the disclosure, a combination of two or more preferred aspects is a more preferred aspect.

In the disclosure, in a case in which a plurality of substances corresponding to each component are present, the content of each component means the total content of the plurality of substances present unless otherwise specified.

In the disclosure, the term "step" includes not only an independent step but also a step by which an intended action of the step is achieved, though the step cannot be clearly distinguished from other steps.

In the disclosure, "extreme ultraviolet ray" (hereinafter, also referred to as "EUV") refers to light having a wavelength of from 1 nm to 30 nm. The wavelength of the EUV is preferably from 5 nm to 13.5 nm.

(1) Nanotube Pellicle Film

A nanotube pellicle film of the disclosure (hereinafter, also referred to as "NT pellicle film") has a ratio of a ventilation resistance to a film thickness (hereinafter, also referred to as "ratio (ventilation resistance/film thickness)" of 0.015 Pa·cm$^2$/(sccm·nm) or more. "sccm" indicates standard Cubic centimeter per minute. "sccm" is 1 cm$^3$/min in a standard state.

In the disclosure, the "nanotube pellicle film" refers to a pellicle film including nanotubes (hereinafter, also referred to as "NT") as a main component. As for the "main component", the content of NT is 80 mass% or more, preferably 90 mass% or more, still more preferably 95 mass% or more, and most preferably 100 mass% with respect to the total amount of the NT pellicle film.

The "ventilation resistance" is an index indicating the difficulty of passing air through the NT pellicle film. The ventilation resistance tends to be higher as the film thickness of the NT pellicle film is thicker. The "ventilation resistance/film thickness" is an index indicating the difficulty of passing air through the NT pellicle film per unit film thickness (1 nm) of the NT pellicle film.

A method of measuring the ventilation resistance is as follows.

The NT pellicle film is fixed to a chamber for a bulge test such that a self-supporting film portion of the NT pellicle film has a square shape of 1 cm × 1 cm. By allowing compressed air to flow into the chamber, the inside of the chamber is brought into a pressurized state, and a pressure $\Delta P$ is applied to the self-supporting film portion of the NT pellicle film. The pressure $\Delta P$ represents a pressure difference (P2 - P1) between a pressure (atmospheric pressure) P1 outside the chamber and a pressure P2 inside the chamber.

A ventilation resistance R is determined by the following Formula (X1).

[Mathematical Formula 1]

$$R = \frac{\Delta P \cdot A}{Q} \qquad (X1)$$

In Formula (X1), "$\Delta P$" represents a pressure difference (P2 - P1) (Pa), "A" represents a ventilation area (cm$^2$) (that is, an area (cm$^2$) of the self-supporting film portion) of the NT pellicle film, and "Q" represents a flow rate (sccm) of the compressed air flowing into the chamber. The pressure P2 inside the chamber can be measured by a differential pressure gauge. The flow rate Q of the compressed air flowing into the chamber can be measured by a flow meter.

Since the NT pellicle film of the disclosure has the above configuration, the film is difficult to break even in the case of having a thin film thickness.

This effect is presumed to be due to the following reason, but is not limited thereto.

The NT pellicle film has a network structure. Specifically, the NT pellicle film has a plurality of three-dimensional spaces (hereinafter, also referred to as "pores") therein. The fact that the ratio (ventilation resistance/film thickness) is 0.015 Pa·cm$^2$/(sccm·nm) or more indicates that the total volume of the plurality of pores per unit film thickness (nm) is small, in other words, the length of the plurality of NTs included in the NT pellicle film is short, the NTs are densely gathered due to van der Waals force, and the number of contacts between the NTs is large. Therefore, a mechanical strength per unit film thickness (nm) of the NT pellicle film of the disclosure is more excellent than a case in which the ratio (ventilation resistance/film thickness) is less than 0.015 Pa·cm$^2$/(sccm·nm) by the sum of van der Waals forces acting on contacts between NTs. As a result, it is presumed that the NT pellicle film of the disclosure is difficult to break even in the case of having a thin film thickness.

(1.1) Physical Properties

(1.1.1) Ratio (Ventilation Resistance/Film Thickness)

The ratio (ventilation resistance/film thickness) is 0.015 Pa·cm$^2$/(sccm·nm) and preferably from 0.015 Pa·cm$^2$/(sccm·nm) to 0.130 Pa·cm$^2$/(sccm·nm). This makes it difficult to break the film even in the case of having a thin film thickness, and makes it possible to reduce the deflection amount of the film even in a case in which the pressure is increased or decreased in the use environment, thereby suppressing interference with the device.

From the viewpoint of high film strength, difficulty in film breakage, and the like, the ratio (ventilation resistance/film thickness) is more preferably 0.020 Pa·cm$^2$/(sccm·nm) or more, still more preferably 0.040 Pa·cm$^2$/(sccm·nm) or more, and still more preferably 0.050 Pa·cm$^2$/(sccm·nm) or more.

From the viewpoint of reducing the deflection amount of the film even in a case in which the pressure is increased or decreased in the use environment, the ratio (ventilation resistance/film thickness) is more preferably 0.100

Pa·cm$^2$/(sccm·nm) or less, still more preferably 0.080 Pa·cm$^2$/(sccm·nm) or less, and still more preferably 0.070 Pa·cm$^2$/(sccm·nm) or less.

Examples of a method of adjusting the ratio (ventilation resistance/film thickness) to 0.015 Pa·cm$^2$/(sccm·nm) or more include a method using an ultra-high pressure homogenizer and a method having a large classification effect (for example, a method using an angle (solid angle rotor) system for centrifugal separation, and the like).

(1.1.2) Transmittance

The transmittance of extreme ultraviolet rays (hereinafter, also referred to as "EUV transmittance") of the NT pellicle film is preferably 88% or more. As a result, the EUV irradiation time during EUV exposure can be shortened as compared with a case in which the EUV transmittance is less than 88%.

The EUV transmittance is preferably as high as possible from the viewpoint of further shortening the EUV irradiation time. The EUV transmittance is more preferably 90% or more, still more preferably 92% or more, and most preferably 100%. From these viewpoints, the EUV transmittance may be from 88% to 100%.

(1.1.2.1) Method of Measuring Transmittance

The EUV transmittance is measured with a photodiode. Specifically, the EUV transmittance is represented by a ratio of a current value detected in a state where the NT pellicle film is installed to a current value detected in a state where the NT pellicle film is not installed. The EUV transmittance tends to decrease linearly with an increase in the film thickness of the NT pellicle film.

Examples of a method of adjusting the EUV transmittance of the NT pellicle film to 88% or more include a method of reducing the film thickness.

(1.1.3) Maximum Stress

The maximum stress of the NT pellicle film is preferably 120 MPa or more.

The "maximum stress" indicates an index of the mechanical strength of the NT pellicle film which does not depend on the film thickness of the NT pellicle film. A method of calculating the maximum stress is the same as the method described in Examples.

The fact that the maximum stress of the NT pellicle film is 120 MPa or more indicates that the mechanical strength of the NT pellicle film is excellent. In the EUV exposure, vacuuming of the inside of the exposure device is performed before the EUV exposure is performed. In a case in which the maximum stress of the NT pellicle film is 120 MPa or more, the NT pellicle film is hardly broken even in a case in which the stress caused by vacuuming acts on the NT pellicle film.

From the viewpoint of, for example, improving the mechanical strength of the NT pellicle film, the maximum stress of the NT pellicle film is preferably as high as possible, more preferably 130 MPa or more, still more preferably 140 MPa or more, and still more preferably 280 MPa or more. From the viewpoint of, for example, easily recovering the film by breaking the film at the time of recovering the film, the maximum stress of the NT pellicle film is preferably 500 MPa or less and more preferably 400 MPa or less. From these viewpoints, the maximum stress of the NT pellicle film may be from 120 MPa to 500 MPa.

A method of measuring the maximum stress of the NT pellicle film is the same as the method described in Examples.

Examples of a method of adjusting the maximum stress of the NT pellicle film to 120 MPa or more include a method using an ultra-high pressure homogenizer and a method having a large classification effect (for example, a method using an angle (solid angle rotor) system for centrifugal separation, and the like).

(1.1.4) Deflection Amount

The deflection amount of the NT pellicle film in a case in which the NT pellicle film is formed into a 1 cm square is preferably 200 μm or less. As a result, it is possible to suppress the deflection amount due to the increase and decrease of the pressure, and it is possible to reduce the possibility of film breakage due to interference with the exposure device and the surrounding environment.

The deflection amount of the NT pellicle film is preferably as small as possible, more preferably 100 μm or less, and still more preferably 50 μm or less from the viewpoint of suppressing the deflection amount due to the increase and decrease of the pressure and reducing the possibility of film breakage due to interference with the exposure device and the surrounding environment. The lower limit of the deflection amount of the NT pellicle film is not particularly limited, but may be, for example, 0 μm or more or 1 μm or more. From these viewpoints, the deflection amount of the NT pellicle film may be from 0 μm to 200 μm, from 0 μm to 50 μm, or from 1 μm to 50 μm.

A method of measuring the deflection amount of the NT pellicle film in a case in which the NT pellicle film is formed into a 1 cm square is as follows.

The NT pellicle film is fixed to a chamber for a bulge test such that a self-supporting film portion of the NT pellicle film has a square shape of 1 cm × 1 cm. A displacement meter (for example, "LJ-V7200" manufactured by KEYENCE CORPORATION) is disposed outside the chamber so as to face the NT pellicle film. By allowing compressed air to flow into the chamber at 10 sccm, the inside of the chamber is brought into a pressurized state. A displacement amount of a position of a central portion of the self-supporting film portion in a pressurized state with respect to a position of the central portion of the self-supporting film portion in a state where no compressed air flows into the chamber was defined as a deflection amount. The displacement amount is measured by a displacement meter.

In a case in which the size of the NT pellicle film is larger than 1 cm × 1 cm, it can be derived by transferring the pellicle film to a frame in which the self-supporting film portion is 1 cm × 1 cm and then measuring the deflection amount.

Examples of a method of adjusting the deflection amount of the NT pellicle film in a case in which the NT pellicle film is formed into a 1 cm square to 200 $\mu$m or less include reducing the ventilation resistance of the NT pellicle film.

(1.2) Nanotube

NT may be a single-walled nanotube (hereinafter, also referred to as "single-walled NT") or a multi-walled nanotube (hereinafter, also referred to as "multi-walled NT").

In the disclosure, the "single-walled nanotube" refers to a nanotube of a single wall. The "multi-walled nanotube" refers to a nanotube of a multi wall.

The plurality of NTs usually form a bundle. The number of NTs forming the bundle is 3 or more, preferably from 4 to 100 and more preferably from 5 to 50. The NT pellicle film may include NT that does not form a bundle.

The NT tube diameter (that is, NT width) may be from 0.4 nm to 50 nm. From the viewpoint of suppressing occurrence of breakage of the NT pellicle film, the NT tube diameter is preferably 0.5 nm or more, more preferably 0.6 nm or more, still more preferably 0.7 nm or more, and particularly preferably 0.8 nm or more. From the viewpoint of improving the EUV transmittance of the NT pellicle film, the NT tube diameter is preferably 30 nm or less, more preferably 15 nm or less, still more preferably 10 nm or less, and particularly preferably 6 nm or less. From these viewpoints, the NT tube diameter may be from 0.4 nm to 50 nm, from 0.4 nm to 15 nm, from 0.4 nm to 10 nm, from 0.4 nm to 6 nm, or from 0.8 nm to 6 nm.

The NT length is preferably 10 nm or more. In a case in which the NT length is 10 nm or more, the NTs are well entangled with each other, and the mechanical strength of the NT pellicle film is excellent. The NT length is preferably 10 cm or less, more preferably 1 cm or less, and still more preferably 100 $\mu$m or less. From these viewpoints, the NT length is preferably from 10 nm to 10 cm, more preferably from 10 nm to 1 cm, and still more preferably from 10 nm to 100 $\mu$m.

The outer diameter and length of the NT tube are arithmetic average values of values measured for 20 or more carbon materials (primary particles) by electron microscope observation.

As an electron microscope, a scanning electron microscope (SEM), a transmission electron microscope (TEM), or the like can be used.

The effective length of NT is preferably 0.1 $\mu$m or more, more preferably 0.5 $\mu$m or more, and still more preferably 1.0 $\mu$m or more from the viewpoint of further increasing the mechanical strength of the NT pellicle film. There is no limitation on the upper limit of the effective length of NT. For example, the effective length of NT may be 30 $\mu$m or less, 20 $\mu$m or less, or 10 $\mu$m or less.

(Measurement of Effective Length of NT)

The effective length of NT is measured by the following method.

First, the far-infrared spectrum of the NT pellicle film is measured using a Fourier transform infrared spectrometer (for example, an FT-IR spectrometer Vertex 80v manufactured by Bruker Corporation, or the like).

Next, the NT pellicle film is transferred onto a high-resistance (that is, low-carrier density) Si substrate.

According to the methods described in Literatures 2 to 4, an NT channel having an "effective length of NT" including a conductive path affected by a kink, a defect, or the like is estimated from a peak value of plasmon resonance, and the effective length of NT is evaluated. An average value of tube diameters is used to calculate the effective length of NT. The average value of the tube diameters can be determined by a method of determining the average value of the diameters of NT obtained by imaging NT with an electron microscope.

[Literature 2] T. Nakanishi, T. Ando, Optical Response of Finite-Length Carbon Nanotubes, J. Phys. Soc. Japan. 78 (2009) 114708.

[Literature 3] T. Morimoto, S. K. Joung, T. Saito, D. N. Futaba, K. Hata, T. Okazaki, Length-dependent plasmon resonance in single-walled carbon nanotubes, ACS Nano. 8 (2014) 9897-9904.

[Literature 4] T. Morimoto, T. Okazaki, Optical resonance in far-infrared spectra of multiwalled carbon nanotubes, Appl. Phys. Express. 8 (2015).

Examples of a method of increasing the effective length of NT include a method using NT with less kink, defects, and the like. The NT with less kink, defects, and the like may be NT having a high degree of crystallinity and excellent linearity.

It is preferable that the NT pellicle film includes a plurality of nanotubes having a tube diameter of from 0.8 nm to 6.0 nm, in which a content ratio of the plurality of nanotubes having a tube diameter of from 0.8 nm to 6.0 nm is 80 mass% or more with respect to the total amount of the nanotube pellicle film.

The NT pellicle film includes a plurality of single-walled nanotubes, and a content ratio of the plurality of single-walled nanotubes is preferably 80 mass% or more with respect to the total amount of the nanotube pellicle film.

The plurality of NTs included in the NT pellicle film are not particularly limited. It is preferable that the NT pellicle film includes a plurality of nanotubes, in which the nanotubes are one selected from the group consisting of carbon nanotubes, boron nitride nanotubes, and transition metal disulfide nanotubes. The transition metal disulfide nanotubes include transition metal disulfide. The transition metal disulfide is represented by $MX_2$. M is at least one selected from the group consisting of Mo, W, Pd, Pt, and Hf. X is at least one selected from the group consisting of S, Se, and Te.

The nanotube preferably includes a carbon nanotube, and is preferably a carbon nanotube. The mechanical strength of CNT is high. Since NT is CNT, the mechanical strength of the NT pellicle film is superior to that in a case in which the material of the NT pellicle film is SiN, polysilicon, or the like.

The transition metal disulfide nanotubes may be composed of transition metal disulfide. The transition metal disulfide may be $MoS_2$, $MoSe_2$, $WS_2$, or $WSe_2$.

Hereinafter, the NT pellicle film including a plurality of CNTs is also referred to as "CNT pellicle film".

(1.3) Ratio (G/D)

A ratio (hereinafter, also referred to as "ratio (G/D)") of a G-band intensity measured by resonance Raman scattering measurement method to a D-band intensity measured by resonance Raman scattering measurement method of the CNT pellicle film is preferably 5 or more.

The "ratio of the G-band intensity measured by resonance Raman scattering measurement method to the D-band intensity measured by resonance Raman scattering measurement method of the CNT pellicle film" is an index indicating how many structural defects are present in each of the plurality of CNTs included in the CNT pellicle film. The "defect" includes that a topological defect is introduced into a network (mesh) in which carbon atoms constituting CNTs are covalently bonded to each other. Topological defects include 5- and 7-membered rings.

The "G-band" is a predominant Raman active mode in graphite structures and is derived from sp2-bonded carbon representing the planar structure of CNTs. The "D-band" is a mode derived from disturbances and defects, such as structural defects and open ends of CNTs. The higher the ratio (G/D), the less structural defects of each of the plurality of CNTs included in the CNT pellicle film.

In the extreme ultraviolet lithography, a photomask including a reflective layer that reflects EUV is used, and the photomask and the optical system are installed in a vacuum chamber. The EUV exposure is performed in a vacuum atmosphere. However, there is a concern that residual gas (for example, moisture, organic substances, and the like) remains in the vacuum chamber, and adhesion of a carbon film or the like (hereinafter, referred to as "contamination") occurs on a surface of a mirror or a mask included in the optical system by irradiation of EUV. The occurrence of contamination may cause a decrease in throughput and deterioration in transfer performance. As a countermeasure against contamination, hydrogen gas is supplied into the vacuum chamber without disassembling and cleaning the optical system, and the generated contamination is cleaned in situ. The hydrogen gas supplied into the vacuum chamber is considered to be turned into hydrogen plasma by irradiation with EUV. A site having a structural defect on the surface of the CNT is likely to appear as a site exhibiting nonlinearity from a microscopic viewpoint (hereinafter, referred to as "non-linear portion"). It is considered that hydrogen plasma mainly promotes the etching of CNTs (that is, CNTs are decomposed and scraped off) starting from the non-linear portion.

The fact that the ratio (G/D) is 5 or more indicates that the number of structural defects of each of the plurality of CNTs included in the CNT pellicle film is small. In a case in which the ratio (G/D) is 15 or more, the etching of CNTs is less likely to be promoted during EUV exposure than a case in which the ratio (G/D) is less than 5. That is, the CNT pellicle film is unlikely to experience film reduction even in the case of being exposed to hydrogen plasma. As a result, an excellent mechanical strength of the CNT pellicle film is maintained.

From the viewpoint of maintaining the mechanical strength of the CNT pellicle film, the ratio (G/D) is preferably as high as possible, more preferably 7 or more, still more preferably 15 or more, and particularly preferably 25 or more. The ratio (G/D) may be 100 or less or 20 or less. From these viewpoints, the ratio (G/D) may be from 5 to 20.

(1.3.1) Method of Measuring Ratio (G/D)

The ratio (G/D) is measured by resonance Raman scattering measurement method using a laser wavelength of 532 nm. For the measurement of the ratio (G/D), for example, "NRS-5100" manufactured by JASCO Corporation may be used.

Specifically, Raman imaging measurement is performed at ten measurement points at intervals of 1 mm on a self-supporting film of a CNT pellicle film of 10 mm $\times$ 10 mm. The D-band intensity is a maximum value among ten measured values of the Raman scattering intensity at a Raman shift in a range of from 1300 $cm^{-1}$ to 1400 $cm^{-1}$. The G-band intensity is a maximum value among ten measured values of the Raman scattering intensity at a Raman shift in a range of from 1550 $cm^{-1}$ to 1610 $cm^{-1}$.

In general Raman spectroscopy, a Raman spectrum of a CNT pellicle film reflects an average structure of CNT chains present inside an irradiation region where the CNT pellicle film is irradiated with laser. In a general micro-Raman spectrometer, an irradiation size of laser is a diameter of about 100 $\mu$m. In the case of a CNT pellicle film made of single-walled CNTs and having a thickness of about 15 nm, the total length of single-walled CNTs included in a spot diameter of 100 $\mu$m is estimated to be from about 1000 $\mu$m to 2000 $\mu$m. In a case in which the number of CNTs is converted on the assumption that the length of one CNT is 1 $\mu$m, the total number of CNTs constituting the CNT pellicle film included in the above-described spot diameter of 100 $\mu$m is from about 1000 to 2000. From these facts, the structural information obtained by a general microscopic Raman apparatus reflects the average structural information of 1000 or more CNTs (1000 $\mu$m or more in length).

(1.4) Film Thickness

The film thickness of the NT pellicle film is not particularly limited, and may be from 2 nm to 200 nm.

From the viewpoint of increasing the EUV transmittance, the film thickness of the NT pellicle film is preferably 100 nm or less, more preferably 50 nm or less, still more preferably 40 nm or less, and particularly preferably 30 nm or less.

From the viewpoint of ease of breakage of the NT pellicle film and the viewpoint of the foreign substance shielding property (that is, the viewpoint of preventing foreign matter from passing through the NT pellicle film), the film thickness of the NT pellicle film is preferably 3 nm or more, more preferably 4 nm or more, and still more preferably 6 nm or more.

(1.4.1) Method of Measuring Film Thickness

The film thickness of the NT pellicle film is determined by transferring a self-supporting film portion of the NT pellicle film onto a silicon substrate and using a reflectance spectroscopic film thickness meter (F50-UV manufactured by Filmetrics, INC.). Specifically, the film thickness is measured as follows.

The "self-supporting film portion of the NT pellicle film" refers to a region, which is not supported by a pellicle frame, of the NT pellicle film.

Specifically, the film thickness is measured as follows.

(1.4.1.1) Transfer

A self-supporting film portion of a NT pellicle film of a pellicle described later is transferred onto a silicon substrate. Specifically, a solvent is dropped onto the silicon substrate, the NT pellicle film of the pellicle is made to face the silicon substrate, and the pellicle is placed on the substrate. Examples of the solvent include water and an organic solvent. The solvent is dried to bring the NT pellicle film into close contact with the silicon substrate without any gap. The self-supporting film portion is separated from the pellicle by fixing the silicon substrate and lifting up the pellicle frame of the pellicle, and the self-supporting film portion is transferred to the substrate.

(1.4.1.2) Measurement of Reflection Spectrum

A reflectance spectrum is measured in a wavelength range of from 200 nm to 600 nm with a wavelength interval of from 1 nm to 2 nm at each measurement point of the self-supporting film portion transferred to the silicon substrate.

In the measurement of the reflectance spectrum, a reflectance spectroscopic film thickness meter (for example, model: F50-UV manufactured by Filmetrics, INC., spot diameter: 1.5 mm) is used as a reflectance measuring device. A silicon wafer is used as a reference for reflection intensity measurement.

A reflectance Rs ($\lambda$) is determined by the following formula.

[Mathematical Formula 2]

$$Rs(\lambda) = \frac{I_s(\lambda)}{I_{ref}(\lambda)} R_{ref}(\lambda)$$

Here, Is ($\lambda$) represents the reflection intensity of the self-supporting film portion on the silicon substrate at a wavelength $\lambda$, Iref ($\lambda$) represents the reflection intensity of a reference, and Rref ($\lambda$) represents the absolute reflectance of a reference.

In a case in which a silicon wafer is used as a reference, Rref ($\lambda$) can be determined by calculation because the optical constant of the silicon wafer is known. The gain, exposure time, and the like are the same conditions for measuring the reflection intensity of the self-supporting film portion on the silicon substrate and the reference. Thus, the absolute reflectance of the self-supporting film portion on the silicon substrate is obtained.

(1.4.1.3) Calculation of Film Thickness

The film thickness at each measurement point of the self-supporting film portion is calculated by analyzing the reflectance spectrum in a wavelength range of from 225 nm to 500 nm by the least squares method using the values of optical constants (refractive index: n, extinction coefficient: k) shown in Table 1 as optical constants of the NT film and the three-layer model of air layer/NT film layer/silicon substrate.

The film thickness at a "measurement position" of the self-supporting film portion is defined as the average value of the film thickness at each of the nine measurement points included in the "measurement position" of the self-supporting film portion. The shape of the self-supporting film portion viewed from the film thickness direction of the self-supporting film portion is rectangular. The diagonal lines of the self-supporting film portion are defined as the X-axis and the Y-axis. As the measurement points in the X-axis direction, three points are set with an interval of 2 mm as the distance between center points at adjacent measurement points, and as the measurement points in the Y-axis direction, three points are set with an interval of 2 mm as the distance between center points at adjacent measurement points. That is, three points in the vertical direction $\times$ three points in the horizontal direction as a total of nine measurement points are set as "measurement positions".

A method of calculating the film thickness at each measurement point of the self-supporting film portion by analyzing the reflectance spectrum in a wavelength range of from 225 nm to 500 nm using the least squares method will be described below.

[Table 1]

| [nm] | n | k |
|------|------|------|
| 225 | 1.20 | 0.61 |
| 248 | 1.34 | 0.75 |
| 276 | 1.52 | 0.76 |
| 310 | 1.64 | 0.72 |
| 354 | 1.71 | 0.68 |
| 413 | 1.75 | 0.68 |
| 496 | 1.81 | 0.70 |

The film thickness of the self-supporting film portion is calculated by the relational expression of the following Formulas (a) to (c) using a three-layer model consisting of air layer/NT film layer/silicon substrate.

The reflectance Rs is represented by the following Formula (a) using an amplitude reflectance $r_s$.

[Mathematical Formula 3]

$$R_S = r_s \cdot r_s^{*} \quad \text{(a)}$$

In the above Formula (a), * represents a complex conjugate.

The amplitude reflectance $r_s$ from the three layers of air layer/NT film layer/silicon substrate is represented by the following Formula (b).
[Mathematical Formula 4]

$$r_s = (r_{01} + r_{12}\exp(-i\delta))/(1 + r_{01}r_{12}\exp(-i\delta)) \quad \text{(b)}$$

In the above Formula (b), $r_{01}$ represents an amplitude reflectance from an interface between the air layer and the self-supporting film portion layer, $r_{12}$ represents an amplitude reflectance from an interface between the self-supporting film portion layer and the silicon substrate, and i represents an imaginary unit.

In the above Formula (b), $\delta$ refers to a phase difference that occurs in a case in which light having wavelength $\lambda$ makes one round trip in the film and is represented by the following Formula (c).
[Mathematical Formula 5]

$$\delta = \left(\frac{4\pi}{\lambda}\right) Nd \ cos\phi \quad \text{(c)}$$

In the above Formula (c), d represents a film thickness of the self-supporting film portion, N represents a complex refractive index (N = n - ik), and $\varphi$ represents an incident angle. i represents an imaginary unit.

The film thickness of the self-supporting film portion can be calculated by the least squares method with the film thickness d as a variable for the reflectance Rs in a wavelength range of from 225 nm to 500 nm using the relational expression of Formulas (a) to (c) above.

The calculated film thickness of the self-supporting film at the "measurement position" is regarded as the film thickness of the NT pellicle film.

(2) Pellicle

A pellicle of the disclosure includes a pellicle frame and the NT pellicle film of the disclosure. The NT pellicle film is supported by the pellicle frame.

Since the pellicle of the disclosure includes the NT pellicle film of the disclosure, the same effect as that of the NT pellicle film of the disclosure is exhibited.

The pellicle frame is a tubular object. The pellicle frame has an end face (hereinafter, referred to as "pellicle film end face") on one side in the thickness direction. The NT pellicle film may be fixed to the pellicle film end face via a bonding adhesive layer.

Examples of a bonding adhesive constituting the bonding adhesive layer include, but are not particularly limited to, an acrylic resin bonding adhesive, an epoxy resin bonding adhesive, a polyimide resin bonding adhesive, a silicone resin bonding adhesive, an inorganic bonding adhesive, a double-sided adhesive tape, a polyolefin-based bonding adhesive, and a hydrogenated styrene-based bonding adhesive. The bonding adhesive is a concept including not only a bonding adhesive but also an adhesive. The thickness of the bonding adhesive layer is, for example, from 10 $\mu$m to 1 mm.

(2.1) Pellicle Frame

The pellicle frame has a through hole for exposure. The through hole for exposure indicates a space through which light transmitted through the NT pellicle film passes such that the light reaches a photomask.

The shape of the pellicle frame in the thickness direction of the pellicle frame is, for example, a rectangular shape. The rectangular shape may be a square or an oblong rectangle.

The pellicle frame has a vent hole. The vent hole is formed, for example, in the side surfaces of the pellicle frame. The vent hole communicates the internal space of the pellicle and the external space of the pellicle in a case in which the pellicle frame is attached to the photomask.

When viewed from the thickness direction, the rectangular pellicle frame is configured by four sides.

The length of one side in the longitudinal direction is preferably 200 mm or less. The size and the like of the pellicle frame are standardized by the type of exposure device. The length of one side of the pellicle frame in the longitudinal direction of 200 mm or less satisfies a size standardized for EUV exposure.

The length of one side in the lateral direction is preferably from 5 mm to 180 mm, more preferably from 80 mm to 170 mm, and still more preferably from 100 mm to 160 mm.

The height of the pellicle frame (that is, the length of the pellicle frame in the thickness direction) is preferably 3.0 mm or less, more preferably 2.4 mm or less, and still more preferably 2.375 mm or less. Thereby, the pellicle frame satisfies a size standardized for EUV exposure. The height of the pellicle frame standardized for EUV exposure is, for example, 2.375 mm.

The mass of the pellicle frame is not particularly limited, and is preferably 20 g or less and more preferably 15 g or less. Thereby, the pellicle frame is suitable for EUV exposure applications.

Examples of the material of the pellicle frame include, but are not particularly limited to, quartz glass, a metal, a carbon-based material, a resin, silicon, and a ceramic-based material.

The metal may be a pure metal or an alloy. A pure metal consists of a single metallic element. Examples of the pure metal include aluminum and titanium. An alloy consists of a plurality of metallic elements or a metallic element and a non-metallic element. Examples of the alloy include stainless steel, a magnesium alloy, steel, carbon steel, and invar. Examples of the resin include polyethylene. Examples of the ceramic-based material include silicon nitride (SiN), silicon carbide (SiC), and alumina ($Al_2O_3$).

The structure of the pellicle frame may be a single item or an assembly. A single item is obtained by cutting one raw material plate. An "assembly" is obtained by integrating a plurality of members. Examples of a method of integrating a plurality of members include known methods using bonding adhesives, fastening parts. Examples of the fastening parts include bolts, nuts, screws, rivets, and pins. In a case in which the pellicle frame is an assembly, the materials of the plurality of members may be different.

(2.2) Adhesive Layer

The pellicle may further include an adhesive layer. The adhesive layer allows the pellicle to adhere to the photomask. The pellicle frame has an end face (hereinafter, referred to as "photomask end face") on the other side in the thickness direction. The adhesive layer is formed on the photomask end face.

The adhesive layer is a gel-like soft solid. The adhesive layer preferable has fluidity and cohesive force. The "fluidity" refers to a property of contacting and getting wet with the photomask as an adherend. The "cohesive force" refers to a property of resisting detachment from the photomask.

The adhesive layer consists of an adhesive resin. Examples of the adhesive resin include, but are not particularly limited to, an acrylic adhesive, a silicone-based adhesive, a styrene-based adhesive, a urethane-based adhesive, and an olefin-based adhesive. The thickness of the adhesive layer is not particularly limited and is preferably from 10 $\mu$m to 500 $\mu$m.

(3) Exposure Original Plate

An exposure original plate of the disclosure includes a photomask and the pellicle of the disclosure. The pellicle of the disclosure is attached to the photomask.

Since the exposure original plate of the disclosure includes the pellicle of the disclosure, the same effect as that of the pellicle of the disclosure is exhibited.

Examples of a method of attaching a photomask to a pellicle (hereinafter, referred to as "attachment method") include, but are not particularly limited to, a method using the adhesive layer described above, a method using fastening parts, and a method using the attractive force of a magnet.

The photomask has a support substrate, a reflective layer, and an absorber layer. It is preferable that the support substrate, the reflective layer, and the absorber layer are layered in this order. In this case, the pellicle is attached to a side of the photomask, on which the reflective layer and the absorber layer are provided.

The absorber layer partially absorbs EUV such that a desired image is formed on a sensitive substrate (for example, a semiconductor substrate attached with a photoresist film). Examples of the reflective layer include a multi-layer film of molybdenum (Mo) and silicon (Si). The material of the absorber layer may be a highly EUV-absorptive material or the like. Examples of the highly EUV-absorptive material or the like include chromium (Cr) and tantalum nitride.

(4) Exposure Device

An exposure device of the disclosure includes, an extreme ultraviolet light source emitting extreme ultraviolet rays as exposure light, the exposure original plate of the disclosure, and an optical system guiding the exposure light emitted from the EUV source to the exposure original plate. The exposure original plate is disposed such that the extreme ultraviolet rays emitted from the extreme ultraviolet light source pass through the nanotube pellicle film to be irradiated on the photomask.

The exposure device of the disclosure has the same effect as that of the exposure original plate of the disclosure. Further, since the exposure device of the disclosure has the above-described configuration, it can form a refined pattern (for example, having a line width of 32 nm or less) and perform pattern exposure with reduced resolution failure due to foreign matter.

As the extreme ultraviolet light source, a known extreme ultraviolet light source can be used. As the optical system, a known optical system can be used.

(5) Method of Producing Nanotube Pellicle Film

The method of producing a NT pellicle film of the disclosure is a method of producing the NT pellicle film of the disclosure. The method of producing a NT pellicle film of the disclosure includes a preparation step, a mixing step, a dispersion step, a purification step, and a film forming step. The preparation step, the mixing step, the dispersion step, the purification step, and the film forming step are carried out in this order.

(5.1) Preparation Step

In the preparation step, a nanotube raw material (hereinafter, also referred to as "NT raw material").
Examples of the method of preparing the NT raw material include, but are not particularly limited to, a method of obtaining a commercially available product, and a method of synthesizing a carbon nanotube raw material (hereinafter, also referred to as "CNT raw material").
Examples of the commercially available product include eDIPS manufactured by Meijo Nano Carbon Co., Ltd., ZEONANO manufactured by Zeon Nano Technology Co., Ltd., and TUBALL manufactured by OCSiAl.
Examples of a method of synthesizing the CNT raw material include an enhanced direct injection pyrolytic synthesis method (hereinafter, also referred to as "eDIPS method"), a super-growth method, and a laser ablation method. Among them, the eDIPS method is preferable as the method of synthesizing the CNT raw material.
The DIPS is a gas phase flow method. Specifically, in the DIPS method, a hydrocarbon-based solution containing a catalyst (or a catalyst precursor) and a reaction accelerator is atomized by spraying and introduced into a high-temperature heating furnace to synthesize a single-walled NT in a flowing gas phase.
The e-DIPS method is a gas phase flow method in which the DIPS method is improved. Specifically, the "e-DIPS method" focuses on a particle formation process in which ferrocene used in a catalyst has a different particle size on the upstream and downstream sides in a reaction furnace, and is relatively easily decomposed in a carrier gas unlike the DIPS method in which only an organic solvent is used as a carbon source. That is, the method is a method in which the growth point of the single-walled NT is controlled by mixing a second carbon source which is likely to be a carbon source. Specifically, production can be carried out with reference to Saitoetal., J. Nanosci. Nanotechnol., 8 (2008) 6153-6157. Examples of commercially available products of the CNT raw material synthesized by the eDIPS method include trade name "MEIJOeDIPS" manufactured by Meijo Nano Carbon Co., Ltd.

(5.2) Mixing Step

In the mixing step, in order to disperse NT while suppressing damage to NT, the NT raw material and a solvent are mixed with a weak mixing force to prepare a first dispersion liquid.
Examples of the method of mixing the NT raw material and the solvent include, but are not particularly limited to, a method using a magnetic stirrer, a method using cavitation (for example, an ultrasonic dispersion method or the like), method of mechanically applying a shear force (for example, a ball mill, a roller mill, a vibration mill, a kneader, a homogenizer, or the like), and a method using turbulence (for example, a jet mill, a nanomizer, or the like).
Examples of the solvent include, but are not particularly limited to, an organic solvent and water. Examples of the organic solvent include isopropyl alcohol, ethanol, toluene, xylene, ethylbenzene, n-methylpyrrolidone, N,N-dimethylformamide, propylene glycol, and methyl isobutyl ketone.
A dispersant may be mixed in addition to the NT raw material and the solvent. The dispersant can unwind thick bundles contained in the NT raw material.
Examples of the dispersant include a flavin derivative, sodium cholate, sodium deoxycholate, sodium dodecylbenzene sulfonate, polyacrylic acid, sodium polyacrylate, polyfluorene (poly(9,9-dioctylfluorenyl-2,7-diyl)), and sodium dodecyl sulfate.
The content of the NT raw material is not particularly limited, and is preferably from 0.0005 mass% to 1 mass% more preferably from 0.001 mass% to 0.5 mass% with respect to the total amount of the first dispersion liquid from the viewpoint of uniformly dispersing the NT raw material in the first dispersion liquid.

(5.3) Dispersion Step

In the dispersion step, the first dispersion liquid is subjected to a dispersion treatment using an ultra-high pressure homogenizer or a stirring type homogenizer to prepare a second dispersion liquid. Thereby, the NT raw material in the first dispersion liquid is uniformly dispersed. As a result, the NT pellicle film of the disclosure is easily obtained.
The ultra-high pressure homogenizer is a device that applies a high pressure to a liquid material to uniformly disperse components (for example, particles and the like) in the liquid material. The ultra-high pressure homogenizer may be any known disperser. The ultra-high pressure homogenizer may be a nozzle type or a valve type, and is preferably a nozzle type from the viewpoint of uniformly dispersing the NT raw material in the first dispersion liquid. In the nozzle type, a high pressure is applied to the liquid material to cause the liquid materials to collide with each other to disperse the components of the liquid material. The nozzle type may be an H-type nozzle.

The pressure of the dispersion treatment is not particularly limited, and is preferably 10 MPa or more, more preferably from 15 MPa to 100 MPa, and still more preferably from 20 MPa to 90 MPa. The number of times of the dispersion treatment may be one or more. As the number of times of the dispersion treatment increases, there is a possibility that structural defects of CNTs are more likely to occur. That is, the ratio (G/D) of the CNT pellicle film may decrease. Therefore, the number of times of the dispersion treatment is preferably from 1 to 10 times and more preferably from 2 to 9 times.

The stirring type homogenizer is a device in which a stirring blade rotates at a high speed to uniformly disperse components in a liquid material. The stirring type homogenizer may be any known disperser.

The rotation speed of the stirring blade is not particularly limited, and is preferably from 1000 rpm to 20000 rpm and still more preferably from 2000 rpm to 19000 rpm. The treatment time is preferably from 1 minute to 5 hours and still more preferably from 5 minutes to 4 hours.

(5.4) Purification Step

In the purification step, the second dispersion liquid is subjected to a purification treatment to produce a third dispersion liquid. Thereby, highly cohesive fibrous nanotubes contained in the first dispersion liquid are removed. As a result, the NT pellicle film of the disclosure is easily obtained.

Examples of the purification treatment method include a method of precipitating aggregates contained in the dispersion liquid (for example, standing, filtration, membrane separation, and a centrifugal treatment (including ultracentrifugal treatment), and it is preferable to use a centrifugal treatment. In the centrifugal treatment, the rotation speed is preferably from 1000 rpm to 30000 rpm. Examples of the centrifugal treatment method include a swing rotor method in which the centrifugal treatment is performed in a state where a container is horizontal, and an angle rotor method in which the centrifugal treatment is performed in a state where a container is inclined at a certain angle. From the viewpoint of having a high effect of removing aggregates, increasing the ratio of the ventilation resistance to the film thickness, or easily increasing the maximum pressure, the centrifugal treatment method is preferably an angle rotor method. In the angle rotor method, the angle at which a container is inclined with respect to the direction of gravity is preferably from 1° to 100° and more preferably from 10° to 60° in order to enhance the centrifugal effect and to easily remove aggregates. From the viewpoint of difficulty in film breakage and the ventilation resistance, the centrifugal treatment method is preferably an angle rotor method.

(5.5) Film Forming Step

In the film forming step, the second dispersion liquid is formed into a film in the form of a sheet to prepare a NT pellicle film of the disclosure.

Examples of a method of forming the second dispersion liquid into a film in the form of a sheet include a method in which the second dispersion liquid is applied onto a substrate and the solvent is removed by drying or the like.

Examples of the coating method include a blade coating method, a slit coating method, a spin coating method, and a dip coating method.

The drying method is not particularly limited as long as it is a known method, and examples thereof include a method in which the solvent is left to stand at room temperature to dry the solvent, and a method in which the solvent is dried by heating.

If necessary, the dispersant may be removed by washing the NT pellicle film with a solvent or the like that dissolves the dispersant in the second dispersion liquid.

Examples

Hereinafter, the disclosure will be described in more detail with reference to Examples; however, the invention of the disclosure is not limited only to these Examples.

[1] Pellicle Film

[1.1]Example 1

A pellicle film was prepared as follows.

[1.1.1] Preparation Step

As a CNT raw material, a single-walled CNT (crude CNT, manufactured by Meijo Nano Carbon Co., Ltd., trade name: EC1.5-P, tube diameter: 1 nm to 3 nm, average value of tube diameter: 1.7 nm, tube length: 100 nm or more, ratio of single-walled CNT: from 80 mass% to 100 mass%) synthesized by an enhanced direct injection pyrolytic synthesis method (eDIPS method) was prepared. The single-walled NT contained aggregates of CNTs.

[1.1.2] Mixing Step

To 30 mg of the CNT raw material, 70 mL of isopropyl alcohol and 30 mL of ethanol were added, 30 mg of polyacrylic acid was further added as an additive, and the mixture was stirred at 1000 rpm (revolutions per minute) for 18 hours using a magnetic stirrer to obtain a first dispersion liquid.

[1.1.3] Dispersion Step

As a disperser, an ultra-high pressure homogenizer ("NAGS20" manufactured by JOKOH CO., LTD.) was prepared. The first dispersion liquid was subjected to a dispersion treatment three times under the condition of 70 MPa using an ultra-high pressure homogenizer. Thereby, a second dispersion liquid was obtained.

[1.1.4] Purification Step

The second dispersion liquid was centrifuged using a swing rotor (Beckman Coulter, Inc., JS-24.15) of a high-speed centrifuge ("JXN-30" manufactured by Beckman Coulter, Inc.) under the conditions of 23000 rpm, 96 minutes, and 10°C. Next, the supernatant was recovered from the first dispersion liquid after the centrifugal treatment to obtain a third dispersion liquid. The precipitate contained aggregates of CNTs and lumpy CNTs.

[1.1.5] Film Forming Step

The third dispersion liquid was spin-coated on a silicon substrate having a size of 4 inches (roughness Ra: 0.15 nm) at a rotation speed of 600 rpm to form a carbon nanotube film (also referred to as "CNT film) on the silicon substrate. Thereby, a silicon substrate attached with a CNT film was obtained.

The CNT film was washed with water to remove polyacrylic acid in the CNT film and dried. Next, the silicon substrate attached with a CNT film was permeated with water. In water, the CNT film was peeled off from the silicon substrate and floated on the water surface. The CNT film was left in water, and the silicon substrate was removed from the water. The CNT film floating on the water surface was scooped with a silicon frame. The silicon frame has a square opening with a side length of 1 cm. Thereby, a pellicle film (CNT film) having a network structure was obtained. The area of the self-supporting film of the CNT pellicle film (that is, the area of the opening of the silicon frame) was $1 \text{ cm}^2$.

[1.2] Example 2

A CNT pellicle film was obtained in the same manner as in Example 1 except that in the dispersion step, the number of times of the dispersion treatment was changed to 10.

[1.3] Example 3

A CNT pellicle film was obtained in the same manner as in Example 1 except that in the dispersion step, the treatment was performed using a stirring type homogenizer ("HF93" manufactured by SMT Corporation) instead of an ultra-high pressure homogenizer under the conditions of a stirring speed of 11000 rpm and a stirring time of 60 minutes, and in the purification step, the purification was performed using an angle rotor (Beckman Coulter, Inc., JLA-12.500) with a fixed angle of a high-speed centrifuge ("JXN-30" manufactured by Beckman Coulter, Inc.) of 30 degrees under the conditions of 13000 rpm, 11 hours, and 10°C.

[1.4] Comparative Example 1

A CNT pellicle film was obtained in the same manner as in Example 1 except that in the dispersion step, a stirring type homogenizer ("HF93" manufactured by SMT Corporation) was used instead of an ultra-high pressure homogenizer. The conditions of the dispersion treatment using the stirring type homogenizer were a stirring speed of 11000 rpm and a stirring time of 60 minutes.

[1.5] Example 4

A CNT pellicle film was obtained in the same manner as in Example 1 except that in the dispersion step, the number of times of the dispersion treatment was changed to 10, and in the purification step, the purification was performed using an angle rotor (Beckman Coulter, Inc., JLA-12.500) with a fixed angle of a high-speed centrifuge ("JXN-30" manufactured by Beckman Coulter, Inc.) of 30 degrees under the conditions of 11000 rpm, 7 hours, and 10°C.

[2] Measurement

The film thickness and the like of the CNT pellicle films of Examples 1 to 4 and Comparative Example 1 were measured by the following method. The measurement results are shown in Table 2.

[2.1]Tube Diameter and Others of CNT

The tube diameter, the film thickness, the ratio (G/D), and the EUV transmittance were measured by the above-described methods.

[2.2] Ventilation Resistance and Others

Measurement is performed by a bulge test of a CNT pellicle film.

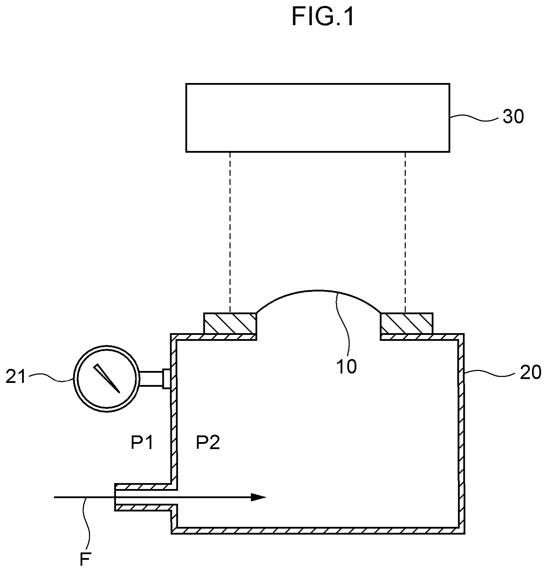

As illustrated in Fig. 1, the CNT pellicle film 10 is fixed to the chamber 20 for a bulge test. The self-supporting film portion of the CNT pellicle film 10 is fixed so as to have a square shape with one side of 1 cm. A displacement meter ("LJ-V7200" manufactured by KEYENCE CORPORATION) was disposed outside the chamber 20 so as to face the CNT pellicle film 10.

By allowing compressed air F to flow into the chamber 20, the inside of the chamber 20 is brought into a pressurized state, and a pressure $\Delta P$ is applied to the self-supporting film portion of the CNT pellicle film 10.

The pressure $\Delta P$ applied to the CNT pellicle film 10 is represented by a difference between the pressure (atmospheric pressure) P1 outside the chamber 20 and the pressure P2 inside the chamber 20. The pressure P2 inside the chamber 20 was measured by a differential pressure gauge 21. $\Delta P$ is adjusted by controlling a flow rate of compressed air flowing into the chamber 20 by a flow meter (not illustrated).

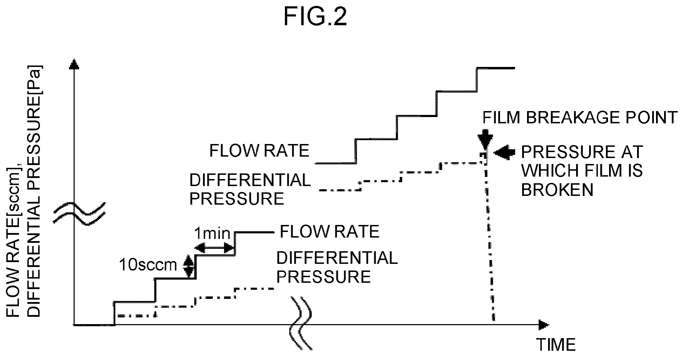

As shown in Fig. 2, the air flow rate flowing into the chamber 20 at intervals of 1 minute was increased by 10 sccm until the CNT pellicle film 10 was broken. The differential pressure $\Delta P$ generated at that time was recorded. For each air flow rate until the film is broken from 10 sccm of the air flow rate $V_{air}$, the inclination (that is, differential pressure $\Delta P \times$ flow rate area/air flow rate $V_{air}$) in a case in which the vertical axis represents the differential pressure $\Delta P \times$ the flow rate area (the flow rate area is 1 cm$^2$ in Examples 1 to 4) and the horizontal axis represents the air flow rate $V_{air}$ is determined, thereby determining the ventilation resistance. The ventilation resistance/film thickness is derived by dividing the ventilation resistance by the film thickness.

[2.2.1] Ventilation Resistance

The ventilation resistance of the CNT pellicle film was measured by the method described above.

[2.2.2] Ratio (Ventilation Resistance/Film Thickness)

The divided value obtained by dividing the measured value of the ventilation resistance by the film thickness of the CNT pellicle film 10 was taken as the "ratio (ventilation resistance/film thickness)".

[2.2.3] Deflection Amount

The deflection amount of the CNT pellicle film in a case in which the CNT pellicle film was formed into a 1 cm square was measured by the method described above.

[2.2.4] Maximum Pressure

A value of the differential pressure ΔP immediately before the CNT pellicle film 10 was broken was taken as the "maximum pressure".

[2.2.5] Maximum Stress

The film stress immediately before the CNT pellicle film 10 was broken was taken as the maximum stress σ. The maximum stress σ was calculated from the following Formula (X2). An allowable range of the maximum stress σ is 50 MPa or more.
[Mathematical Formula 6]

$$\sigma = \frac{\Delta P \cdot a^2}{2 \cdot d \cdot t \cdot 10^6} \qquad (X2)$$

In Formula (X2), "ΔP" represents the pressure difference (P2 - P1) (Pa), "a" represents 1/2 (m) of the short-side length of the self-supporting film portion (that is, "a" represents 0.005 m), "d" represents the deflection amount (m) of the CNT pellicle film, and "t" represents the film thickness (m) of the CNT pellicle film.

[Table 2]

| Pellicle film | | Unit | Example 1 | Example 2 | Example 3 | Comparative Example 1 | Example 4 |
|---|---|---|---|---|---|---|---|
| Configuration | Main component | - | Single-walled CNT | Single-walled CNT | Single-walled CNT | Single-walled CNT | Single-walled CNT |
| | Ratio of main component | mass% | 80~100 | 80~100 | 80~100 | 80~100 | 80~100 |
| | Tube diameter | nm | 1~3 | 1~3 | 1~3 | 1~3 | 1~3 |
| | Area of self-supporting film | cm$^2$ | 1 | 1 | 1 | 1 | 1 |
| | Film thickness | nm | 20 | 24 | 18 | 17 | 24 |
| | Ratio (G/D) | - | 38 | 22 | 39 | 25 | 9 |
| Physical properties | Ventilation resistance | Pa·cm$^2$/sccm | 0.72 | 1.47 | 1.11 | 0.23 | 1.83 |
| | Ratio (ventilation resistance/film thickness) | Pa·cm$^2$/(sccm·nm) | 0.036 | 0.061 | 0.062 | 0.014 | 0.076 |
| | EUV transmittance | % | 94 | 92 | - | 94~95 | - |
| | Deflection amount | μm | 15 | 91 | 68 | 73 | 130 |
| Dispersion step | Disperser | - | Ultra-high pressure type | Ultra-high pressure type | Stirring type | Stirring type | Ultra-high pressure type |
| | Number of times of treatment | times | 3 | 10 | 1 | 1 | 10 |

(continued)

| Pellicle film | | Unit | Example 1 | Example 2 | Example 3 | Comparative Example 1 | Example 4 |
|---|---|---|---|---|---|---|---|
| Purification step | Centrifugal treatment method | - | Swing | Swing | Angle | Swing | Angle |
| Evaluation | Maximum pressure | Pa | 106 | 118 | 240 | 50 | 231 |
| | Maximum stress | MPa | 166 | 164 | 332 | 99 | 281 |

In Table 2, the "ultra-high pressure type" refers to an ultra-high pressure homogenizer. The "stirring type" refers to a stirring type homogenizer. The "swing" indicates that the centrifugal treatment method is a swing rotor method. The "angle" indicates that the centrifugal treatment method is an angle rotor method.

In the CNT pellicle film of Comparative Example 1, the ratio (ventilation resistance/film thickness) was less than 0.015 Pa· $cm^2$/(sccm·nm). Therefore, the maximum stress was less than 100 MPa. As a result, it was found that the pellicle film of Comparative Example 1 is not a nanotube pellicle film which is difficult to break even in the case of having a thin film thickness.

In the CNT pellicle films of Examples 1 to 4, the ratio (ventilation resistance/film thickness) was 0.015 Pa· $cm^2$/(sccm·nm) or more. Therefore, the maximum stress was 100 MPa or more. As a result, it was found that the pellicle films of Examples 1 to 4 are a nanotube pellicle film which is difficult to break even in the case of having a thin film thickness.

The entire contents of the disclosures by Japanese Patent Application No. 2023-015650 filed on February 3, 2023 are incorporated herein by reference.

All the literature, patent application, and technical standards cited herein are also herein incorporated to the same extent as provided for specifically and severally with respect to an individual literature, patent application, and technical standard to the effect that the same should be so incorporated by reference.

## Claims

1.    A nanotube pellicle film having a ratio of ventilation resistance to a film thickness of 0.015 Pa·$cm^2$/(sccm·nm) or more.

2.    The nanotube pellicle film according to claim 1, comprising a plurality of nanotubes having a tube diameter of from 0.8 nm to 6.0 nm,
   wherein a content ratio of the plurality of nanotubes is 80 mass% or more with respect to a total amount of the nanotube pellicle film.

3.    The nanotube pellicle film according to claim 1, comprising a plurality of single-walled nanotubes,
   wherein a content ratio of the plurality of single-walled nanotubes is 80 mass% or more with respect to a total amount of the nanotube pellicle film.

4.    The nanotube pellicle film according to claim 1, wherein the ratio is from 0.015 Pa·$cm^2$/(sccm·nm) to 0.130 Pa· $cm^2$/(sccm·nm).

5.    The nanotube pellicle film according to claim 1, comprising a plurality of carbon nanotubes,
   wherein a ratio of a G-band intensity measured by resonance Raman scattering measurement method to a D-band intensity measured by resonance Raman scattering measurement method is 5 or more.

6.    The nanotube pellicle film according to claim 1, comprising a plurality of nanotubes,

   wherein the nanotubes are one selected from the group consisting of carbon nanotubes, boron nitride nanotubes, and transition metal disulfide nanotubes,
   the transition metal disulfide nanotubes include a transition metal disulfide,
   the transition metal disulfide is represented by $MX_2$,
   M is at least one selected from the group consisting of Mo, W, Pd, Pt, and Hf, and
   X is at least one selected from the group consisting of S, Se, and Te.

7. The nanotube pellicle film according to claim 6, wherein the nanotubes are carbon nanotubes.

8. The nanotube pellicle film according to claim 1, wherein a transmittance of extreme ultraviolet rays is 88% or more.

9. The nanotube pellicle film according to claim 1, wherein a maximum stress is 120 MPa or more.

10. The nanotube pellicle film according to claim 1, wherein a deflection amount in a case in which the nanotube pellicle film is formed into a 1 cm square is 200 $\mu$m or less.

11. A pellicle, comprising:

   a pellicle frame; and
   the pellicle film according to any one of claims 1 to 10, supported by the pellicle frame.

12. An exposure original plate, comprising:

   a photomask; and
   the pellicle according to claim 11, attached to the photomask.

13. An exposure device, comprising:

   an extreme ultraviolet light source emitting extreme ultraviolet rays as exposure light;
   the exposure original plate according to claim 12; and
   an optical system guiding the exposure light emitted from the extreme ultraviolet light source to the exposure original plate,
   wherein the exposure original plate is disposed such that the extreme ultraviolet rays emitted from the extreme ultraviolet light source pass through the nanotube pellicle film to be irradiated on the photomask.

# FIG.1

# FIG.2

## INTERNATIONAL SEARCH REPORT

| International application No. |
| --- |
| **PCT/JP2024/000599** |

| A. | CLASSIFICATION OF SUBJECT MATTER |
| --- | --- |

*G03F 1/62*(2012.01)i; *C01B 32/168*(2017.01)i
FI:   G03F1/62; C01B32/168

According to International Patent Classification (IPC) or to both national classification and IPC

| B. | FIELDS SEARCHED |
| --- | --- |

Minimum documentation searched (classification system followed by classification symbols)

G03F1/62; C01B32/158

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | WO 2021/210432 A1 (MITSUI CHEMICALS, INC.) 21 October 2021 (2021-10-21) paragraphs [0080]-[0087], [0117]-[0122], [0133]-[0134], table 2 | 1-13 |
| Y | | 6, 11-13 |
| X | WO 2022/030499 A1 (MITSUI CHEMICALS, INC.) 10 February 2022 (2022-02-10) paragraphs [0018], [0115], [0127], fig. 1-2 | 1-13 |
| Y | | 6, 11-13 |
| Y | JP 2022-547393 A (ASML NETHERLANDS B.V.) 14 November 2022 (2022-11-14) paragraphs [0106]-[0110] | 6, 11-13 |
| A | | 1-5, 7-10 |
| A | JP 2023-004883 A (KUSUMOTO KASEI KK) 17 January 2023 (2023-01-17) paragraphs [0031]-[0035] | 1-13 |

☑ Further documents are listed in the continuation of Box C.       ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **01 March 2024** | **19 March 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

International application No.

**PCT/JP2024/000599**

**C.    DOCUMENTS CONSIDERED TO BE RELEVANT**

| Category* | Citation of document, with indication, where appropriate, of the relevant passages | Relevant to claim No. |
|---|---|---|
| A | Avanti JXN30 高速冷却遠心機, ベックマン・コールター株式会社, [online], [retrieved on 01 March 2024], Internet: <URL: https://www.beckman.jp/centrifuges/high-speed/avanti-jxn-30>, (High speed centrifuge, BECKMAN COULTER, INC,)<br>features | 1-13 |

Form PCT/ISA/210 (second sheet) (July 2022)

## INTERNATIONAL SEARCH REPORT
### Information on patent family members

International application No.

**PCT/JP2024/000599**

| Patent document<br>cited in search report | | | Publication date<br>(day/month/year) | Patent family member(s) | | | Publication date<br>(day/month/year) |
|---|---|---|---|---|---|---|---|
| WO | 2021/210432 | A1 | 21 October 2021 | US | 2023/0194977 | A1 | |
| | | | | paragraphs [0226]-[0247],<br>[0329]-[0341], [0364], table 2 | | | |
| | | | | EP | 4120017 | A1 | |
| | | | | KR | 10-2022-0154184 | A | |
| | | | | CN | 115398334 | A | |
| | | | | CN | 117270313 | A | |
| | | | | CN | 117270314 | A | |
| | | | | TW | 202140378 | A | |
| | | | | JP | 2023-106455 | A | |
| WO | 2022/030499 | A1 | 10 February 2022 | US | 2023/0244138 | A1 | |
| | | | | paragraphs [0074], [0313]-<br>[0318], [0337]-[0350], fig. 1-2 | | | |
| | | | | EP | 4170428 | A1 | |
| | | | | KR | 10-2023-0014781 | A | |
| | | | | CN | 115836248 | A | |
| | | | | TW | 202206940 | A | |
| JP | 2022-547393 | A | 14 November 2022 | US | 2022/0276553 | A1 | |
| | | | | paragraphs [0111]-[0115] | | | |
| | | | | WO | 2021/037662 | A1 | |
| | | | | EP | 4022392 | A1 | |
| | | | | KR | 10-2022-0047581 | A | |
| | | | | CN | 114286965 | A | |
| | | | | TW | 202117441 | A | |
| | | | | NL | 2026303 | A | |
| | | | | IL | 290239 | A | |
| | | | | CA | 3149349 | A1 | |
| JP | 2023-004883 | A | 17 January 2023 | (Family: none) | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022060877 A1

- JP 2023015650 A

**Non-patent literature cited in the description**

- **T. NAKANISHI** ; **T. ANDO**. Optical Response of Finite-Length Carbon Nanotubes. *J. Phys. Soc. Japan*, 2009, vol. 78, 114708
- **T. MORIMOTO** ; **S. K. JOUNG** ; **T. SAITO** ; **D. N. FUTABA** ; **K. HATA** ; **T. OKAZAKI**. Length-dependent plasmon resonance in single-walled carbon nanotubes. *ACS Nano.*, 2014, vol. 8, 9897-9904

- **T. MORIMOTO** ; **T. OKAZAKI**. Optical resonance in far-infrared spectra of multiwalled carbon nanotubes. *Appl. Phys. Express*, 2015, vol. 8
- **SAITO et al.** *J. Nanosci. Nanotechnol.*, 2008, vol. 8, 6153-6157